(19) **Europäisches Patentamt / European Patent Office / Office européen des brevets**

(11) **EP 4 711 971 A1**

(12) **EUROPEAN PATENT APPLICATION**
published in accordance with Art. 153(4) EPC

(43) Date of publication:
**18.03.2026  Bulletin 2026/12**

(21) Application number: **24818420.2**

(22) Date of filing: **30.04.2024**

(51) International Patent Classification (IPC):
***G06F 30/27*** (2020.01)

(52) Cooperative Patent Classification (CPC):
**G06F 30/27; G06N 3/0464; G06N 3/08**

(86) International application number:
**PCT/CN2024/090976**

(87) International publication number:
**WO 2024/250886 (12.12.2024 Gazette 2024/50)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **05.06.2023  CN 202310657765**

(71) Applicant: **Huawei Technologies Co., Ltd.**
**Shenzhen, Guangdong 518129 (CN)**

(72) Inventors:
• **WANG, Ziyu**
  **Shenzhen, Guangdong 518129 (CN)**
• **LU, Jiaxun**
  **Shenzhen, Guangdong 518129 (CN)**
• **DING, Bowen**
  **Shenzhen, Guangdong 518129 (CN)**
• **XIE, Daqi**
  **Shenzhen, Guangdong 518129 (CN)**
• **SHAO, Yunfeng**
  **Shenzhen, Guangdong 518129 (CN)**
• **WU, Qibin**
  **Shenzhen, Guangdong 518129 (CN)**

(74) Representative: **Pfenning, Meinig & Partner mbB**
**Patent- und Rechtsanwälte**
**Theresienhöhe 11a**
**80339 München (DE)**

(54) **MODEL PARAMETER OPTIMIZATION METHOD AND RELATED SYSTEM, AND STORAGE MEDIUM**

(57)    Embodiments of this application provide a model parameter optimization method, a related system, and a storage medium. The method includes: obtaining a plurality of reference values of a parameter of a first model (301); traversing the plurality of reference values based on preset model evaluation information, the first model, and a prior data pair of the first model, to obtain at least one target value of the parameter (302), where a loss value that is of a model on the prior data pair and that corresponds to the target value is not greater than an upper bound of a loss value of a model on the prior data pair in the preset model evaluation information, and/or a test accuracy value that is of the model on the prior data pair and that corresponds to the target value is not less than a lower bound of a test accuracy value of the model on the prior data pair; determining an optimized value of the parameter based on the at least one target value, the prior data pair of the first model, and a posterior data pair of the first model (303); and updating the parameter of the first model based on the optimized value (304). In this way, model accuracy can be improved.

Obtain a plurality of reference values of a parameter of a first model based on a prior data pair of the first model and a posterior data pair of the first model — 301

Traverse the plurality of reference values based on preset model evaluation information, the first model, and the prior data pair, to obtain at least one target value of the parameter — 302

Determine an optimized value of the parameter based on the at least one target value, the prior data pair, and the posterior data pair — 303

Update the parameter of the first model based on the optimized value — 304

FIG. 3

EP 4 711 971 A1

## Description

This application claims priority to Chinese Patent Application No. 202310657765.1, filed with the China National Intellectual Property Administration on June 5, 2023, and entitled "MODEL PARAMETER OPTIMIZATION METHOD, RELATED SYSTEM, AND STORAGE MEDIUM", which is incorporated herein by reference in its entirety.

## TECHNICAL FIELD

This application relates to the field of artificial intelligence (Artificial Intelligence, AI) technologies, and in particular, to a model parameter optimization method, a related system, and a storage medium.

## BACKGROUND

Artificial intelligence AI is a theory, a method, a technology, or an application system that simulates, extends, and expands human intelligence by using a digital computer or a machine controlled by a digital computer, to perceive an environment, obtain knowledge, and achieve an optimal result based on the knowledge. In other words, artificial intelligence is a branch of computer science and is intended to understand essence of intelligence and produce a new intelligent machine that can react in a manner similar to that of human intelligence. The artificial intelligence is to research design principles and implementation methods of various intelligent machines, so that the machines have perception, inference, and decision-making functions. Research in the field of the artificial intelligence includes robotics, natural language processing, computer vision, decision-making and inference, human-machine interaction, recommendation and search, AI basic theories, and the like.

Neural networks have been successfully applied in a plurality of fields, including computer vision, machine translation, speech recognition, and the like. After a machine learning model is successfully trained based on prior data, a parameter of the model usually needs to be adjusted based on posterior data. Because a data domain used during training is limited, it is difficult to train a model with a sufficient generalization capability. When a model is put into commercial use, a quantity of samples that can be collected is extremely limited. The model needs to perform few-shot learning with an excessively small quantity of samples, to adapt to a data distribution of a target data domain and achieve high model accuracy to support commercial use.

Currently, a sampling-based Bayesian model optimization method obtains a posterior distribution of a parameter of a model based on a prior distribution of the parameter, a loss value of the model on prior data, and a loss value of the model on posterior data, to obtain an optimized value of the parameter. In this optimization algorithm, the prior distribution is in direct proportion to an amount of the prior data, and the posterior distribution is in direct proportion to an amount of the posterior data. As the prior data increases, a difference between an optimal value and a non-optimal value that correspond to the loss value of the model also increases in direction proportion. As a result, the prior distribution of the parameter is exponentially concentrated near an optimal prior parameter. Consequently, the posterior data has little impact on the posterior distribution of the parameter, which results in low model accuracy.

## SUMMARY

This application discloses a model parameter optimization method, a related system, and a storage medium, to avoid introducing a complex hyperparameter for balancing an amount of prior data and an amount of posterior data during parameter optimization, and improve model accuracy.

According to a first aspect, an embodiment of this application provides a model parameter optimization method. The method may include:

　　obtaining a plurality of reference values of a parameter of a first model based on a prior data pair of the first model and a posterior data pair of the first model;

　　traversing the plurality of reference values based on preset model evaluation information, the first model, and the prior data pair, to obtain at least one target value of the parameter, where a loss value that is of a model on the prior data pair and that corresponds to the target value is not greater than an upper bound of a loss value of a model on the prior data pair in the preset model evaluation information, and/or a test accuracy value that is of the model on the prior data pair and that corresponds to the target value is not less than a lower bound of a test accuracy value of the model on the prior data pair in the preset model evaluation information;

　　determining an optimized value of the parameter based on the at least one target value, the prior data pair, and the posterior data pair; and

　　updating the parameter of the first model based on the optimized value.

In this embodiment of this application, based on the plurality of reference values of the parameter of the first model, the plurality of reference values are traversed based on the preset model evaluation information and the prior data pair, to obtain the at least one target value of the parameter, and then the optimized value of the parameter is determined based on the target value and the prior data pair and the posterior data pair of the first model, to update the first model based on the optimized value. In this manner, the loss value that is of the model on the prior data pair and that corresponds to the target value of the parameter is not greater than the upper bound of the loss value of the model, and/or the test accuracy value that is of the model on the prior data pair and that corresponds to the target value is not less than the lower bound of the test accuracy value of the model, so that the obtained optimized value of the parameter can guarantee the prior data pair at the same time. The optimized value of the parameter is determined based on the target value and the prior data pair and the posterior data pair of the first model, so that it is ensured that the optimized value of the parameter can take the posterior data pair into consideration, and performance is better. In addition, a posterior distribution of the parameter of the model is not affected by a quantity of prior data pairs, so that performance is better.

The preset model evaluation information may include the upper bound of the loss value of the model and/or the lower bound of the test accuracy value of the model. Certainly, the preset model evaluation information may alternatively be other evaluation information.

The loss value that is of the model on the prior data pair and that corresponds to the target value is not greater than the upper bound of the loss value of the model on the prior data pair in the preset model evaluation information. It may be understood that, taking each of different data domains that prior data pairs respectively belong to as a unit, a data domain, with a greatest average loss value, corresponding to the model and corresponding to the target value satisfies the following: The average loss value of the data domain is not greater than the upper bound of the loss value of the model in the preset model evaluation information. Alternatively, a loss value that is of the model on each of the prior data pairs and that corresponds to the target value may not be greater than the upper bound of the loss value of the model in the preset model evaluation information.

Correspondingly, the test accuracy value that is of the model on the prior data pair and that corresponds to the target value is not less than the lower bound of the test accuracy value of the model on the prior data pair in the preset model evaluation information. It may be understood that, taking each of different data domains that prior data pairs respectively belong to as a unit, a data domain, with a smallest average test accuracy value, corresponding to the model and corresponding to the target value satisfies the following: The average test accuracy value of the data domain is not less than the lower bound of the test accuracy value of the model in the preset model evaluation information. Alternatively, a test accuracy value that is of the model on each of the prior data pairs and that corresponds to the target value may not be less than the lower bound of the test accuracy value of the model in the preset model evaluation information.

In a possible implementation, an average loss value that is of the model in each training data domain and that corresponds to each reference value may be solved (for example, for a training data domain A, a loss value of each prior data pair in the training data domain A is calculated, and then an average value of the loss values of the prior data pairs in the training data domain A is solved based on a quantity of prior data pairs in the training data domain A), and then a training data domain with a greatest average loss value is obtained. If a loss value of the training data domain with the greatest average loss value is not less than the upper bound of the loss value of the model in the preset model evaluation information, this reference value is denoted as the target value. If a loss value of the training data domain with the greatest average loss value is greater than the upper bound of the loss value of the model in the preset model evaluation information, this reference value is discarded.

In another possible implementation, a loss value that is of the model on each prior data pair and that corresponds to each reference value is solved, to determine a greatest loss value. If the greatest loss value is not less than the upper bound of the loss value of the model in the preset model evaluation information, this reference value is denoted as the target value.

Certainly, there may alternatively be another selection manner. This is not limited in this solution.

In a possible implementation, determining the optimized value of the parameter based on the at least one target value, the prior data pair, and the posterior data pair includes:

obtaining a prior distribution of the parameter of the first model based on the prior data pair;
obtaining a loss value of the first model on the posterior data pair based on the posterior data pair and the at least one target value;
obtaining a posterior distribution of the parameter based on the prior distribution of the parameter and the loss value of the first model on the posterior data pair; and
determining the optimized value of the parameter based on the posterior distribution of the parameter.

In a possible implementation, a value that is of the parameter and that corresponds to a maximum probability in the posterior distribution of the parameter is determined as the optimized value of the parameter.

In this way, the obtained optimized value of the parameter is optimal on the posterior data pair.

In another possible implementation, determining the optimized value of the parameter based on the posterior distribution of the parameter includes:

performing sampling based on the posterior distribution of the parameter to obtain a plurality of values of the parameter; and
performing weighted averaging processing on the plurality of values of the parameter, to obtain the optimized value of the parameter.

Through this example, uncertainty estimation of a prediction result of the model can be implemented.
In a possible implementation, the parameter is all parameters of the first model.
In another possible implementation, the parameter is a part of parameters of the first model, the first model sequentially includes a feature extraction model and a classification model, and the part of parameters are parameters corresponding to the classification model.
Traversing the plurality of reference values based on the preset model evaluation information, the first model, and the prior data pair, to obtain the at least one target value of the parameter includes:

obtaining a prior feature data pair based on the prior data pair and the feature extraction model; and
traversing the plurality of reference values based on the preset model evaluation information, the classification model, and the prior feature data pair, to obtain the at least one target value of the parameter.

Determining the optimized value of the parameter based on the at least one target value, the prior data pair, and the posterior data pair includes:

obtaining a posterior feature data pair based on the posterior data pair and the feature extraction model; and
determining the optimized value of the parameter based on the at least one target value, the prior feature data pair, the posterior feature data pair, and the classification model.

The classification model is updated based on the determined optimized value of the parameter, to obtain an optimized classification model, so that an optimized first model can be obtained. In this process, the feature extraction model may not be updated. Based on the foregoing parameter optimization processing, the first model can take both the prior data pair and the posterior data pair into consideration. In addition, the posterior distribution of the parameter of the model is not affected by the quantity of prior data pairs, so that performance is better.
According to a second aspect, an embodiment of this application provides a model parameter optimization apparatus, including:

an obtaining module, configured to obtain a plurality of reference values of a parameter of a first model based on a prior data pair of the first model and a posterior data pair of the first model;
a calculation module, configured to traverse the plurality of reference values based on preset model evaluation information, the first model, and the prior data pair, to obtain at least one target value of the parameter, where a loss value that is of a model on the prior data pair and that corresponds to the target value is not greater than an upper bound of a loss value of a model on the prior data pair in the preset model evaluation information, and/or a test accuracy value that is of the model on the prior data pair and that corresponds to the target value is not less than a lower bound of a test accuracy value of the model on the prior data pair in the preset model evaluation information;
a determining module, configured to determine an optimized value of the parameter based on the at least one target value, the prior data pair, and the posterior data pair; and
an updating module, configured to update the parameter of the first model based on the optimized value.

In a possible implementation, the determining module is configured to:

obtain a prior distribution of the parameter of the first model based on the prior data pair;
obtain a loss value of the first model on the posterior data pair based on the posterior data pair and the at least one target value;
obtain a posterior distribution of the parameter based on the prior distribution of the parameter and the loss value of the first model on the posterior data pair; and
determine the optimized value of the parameter based on the posterior distribution of the parameter.

In a possible implementation, a value that is of the parameter and that corresponds to a maximum probability in the posterior distribution of the parameter is determined as the optimized value of the parameter.

In another possible implementation, the determining module is further configured to:

perform sampling based on the posterior distribution of the parameter to obtain a plurality of values of the parameter; and

perform weighted averaging processing on the plurality of values of the parameter, to obtain the optimized value of the parameter.

In a possible implementation, the parameter is all parameters of the first model.

In another possible implementation, the parameter is a part of parameters of the first model, the first model sequentially includes a feature extraction model and a classification model, and the part of parameters are parameters corresponding to the classification model.

The calculation module is configured to:

obtain a prior feature data pair based on the prior data pair of the first model and the feature extraction model; and

traverse the plurality of reference values based on the preset model evaluation information, the classification model, and the prior feature data pair, to obtain the at least one target value of the parameter.

The determining module is configured to:

obtain a posterior feature data pair based on the posterior data pair of the first model and the feature extraction model; and

determine the optimized value of the parameter based on the at least one target value, the prior feature data pair, the posterior feature data pair, and the classification model.

According to a third aspect, this application provides a model parameter optimization apparatus, including a processor and a memory. The memory is configured to store program code, and the processor is configured to invoke the program code to perform the method.

According to a fourth aspect, this application provides a computer storage medium, including computer instructions. When the computer instructions are run on an electronic device, the electronic device is enabled to perform the method according to any one of the possible implementations of the first aspect.

According to a fifth aspect, an embodiment of this application provides a computer program product. When the computer program product runs on a computer, the computer is enabled to perform the method according to any one of the possible implementations of the first aspect.

According to a sixth aspect, an embodiment of this application provides a chip. The chip includes a processor and a data interface, and the processor reads, through the data interface, instructions stored in a memory, to perform the method according to any one of the possible implementations of the first aspect.

Optionally, as an implementation, the chip may further include the memory. The memory stores the instructions, and the processor is configured to execute the instructions stored in the memory. When the instructions are executed, the processor is configured to perform the method according to any one of the possible implementations of the first aspect.

It may be understood that the apparatus according to the second aspect, the apparatus according to the third aspect, the computer storage medium according to the fourth aspect, the computer program product according to the fifth aspect, or the chip according to the sixth aspect provided above is all configured to perform the method according to any one of the possible implementations of the first aspect.

Therefore, for beneficial effect that can be achieved by the apparatus according to the second aspect, the apparatus according to the third aspect, the computer storage medium according to the fourth aspect, the computer program product according to the fifth aspect, or the chip according to the sixth aspect, refer to the beneficial effect in the corresponding method. Details are not described herein again.

## BRIEF DESCRIPTION OF DRAWINGS

The following describes the accompanying drawings used in embodiments of this application.

FIG. 1 is a diagram of an architecture of a model parameter optimization system according to an embodiment of this application;

FIG. 2a is a diagram of an architecture of a model training system according to an embodiment of this application;

FIG. 2b is a diagram of a structure of a convolutional neural network according to an embodiment of this application;

FIG. 3 is a schematic flowchart of a model parameter optimization method according to an embodiment of this application;

FIG. 4 is a schematic flowchart of another model parameter optimization method according to an embodiment of this application;

FIG. 5a is a diagram of model training according to an embodiment of this application;

FIG. 5b is a diagram of a model parameter optimization scenario according to an embodiment of this application;

FIG. 6 is a diagram of a structure of a model parameter optimization apparatus according to an embodiment of this application; and

FIG. 7 is a diagram of a structure of another model parameter optimization apparatus according to an embodiment of this application.

## DESCRIPTION OF EMBODIMENTS

The following describes embodiments of this application with reference to the accompanying drawings in embodiments of this application. Terms used in implementations of embodiments of this application are merely used to explain specific embodiments of this application, and are not intended to limit this application.

During model parameter optimization in a conventional technology, as prior data increases, a difference between an optimal value and a non-optimal value that correspond to a loss value of a model also increases in direction proportion. As a result, a prior distribution of the parameter is exponentially concentrated near an optimal prior parameter. Consequently, posterior data has little impact on a posterior distribution of the parameter, which results in low model accuracy. In view of this, this application provides a model parameter optimization method, a related system, and a storage medium, to avoid introducing a complex hyperparameter for balancing an amount of prior data and an amount of posterior data during parameter optimization, and improve model accuracy.

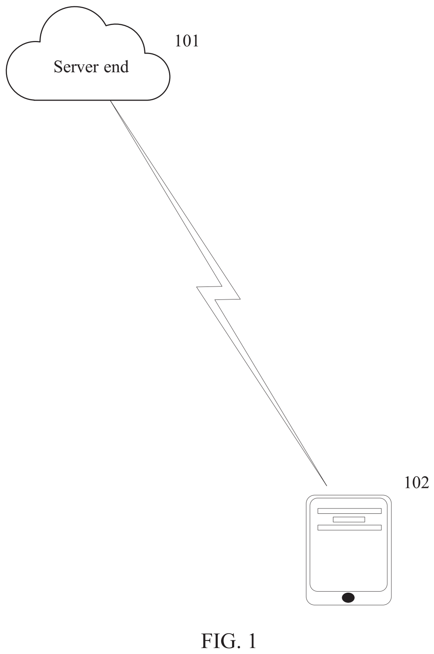

The following describes in detail a system architecture in embodiments of this application with reference to the accompanying drawings. FIG. 1 is a diagram of a model parameter optimization system to which embodiments of this application are applicable. The system includes a server end 101 and a client 102.

The server end 101 is an apparatus having a centralized computing capability. For example, the server end 101 may be implemented by using an apparatus such as a server, a virtual machine, a cloud, or a robot.

When the server end 101 includes the server, a type of the server includes but is not limited to a general-purpose computer, a dedicated server computer, a blade server, or the like. A quantity of servers included in the server end 101 is not strictly limited in this application, and there may be one or more servers (for example, a server cluster).

The virtual machine is a software-simulated calculation module that has complete hardware system functions and that runs in an entirely isolated environment. Certainly, in addition to the virtual machine, the server end 101 may be implemented by using another computing instance, for example, a container.

The cloud is a software platform that uses an application virtualization technology, and can enable one or more pieces of software and applications to be developed and run in an independent virtualized environment. Optionally, when the server end 101 is implemented by using the cloud, the cloud may be deployed on a public cloud, a private cloud, a hybrid cloud, or the like.

The client 102 is also referred to as a user end, and is a program that corresponds to the server and provides a local service for a customer. The client 102 in this embodiment of this application may be a handheld terminal, a wearable device, an entertainment device, or the like.

In this embodiment of this application, the client 102 may transmit data to the server end 101. The server end determines an optimized value of a parameter, and then sends the optimized value to the client 102, so that the client 102 performs model parameter update.

In another possible implementation, the model parameter optimization system may include only the client 102. That is, the client 102 may independently complete model parameter update.

In still another possible implementation, the model parameter optimization system may include only the server end 101. That is, the server end 101 may independently complete model parameter update.

Certainly, another manner may alternatively be used. This is not limited in this solution.

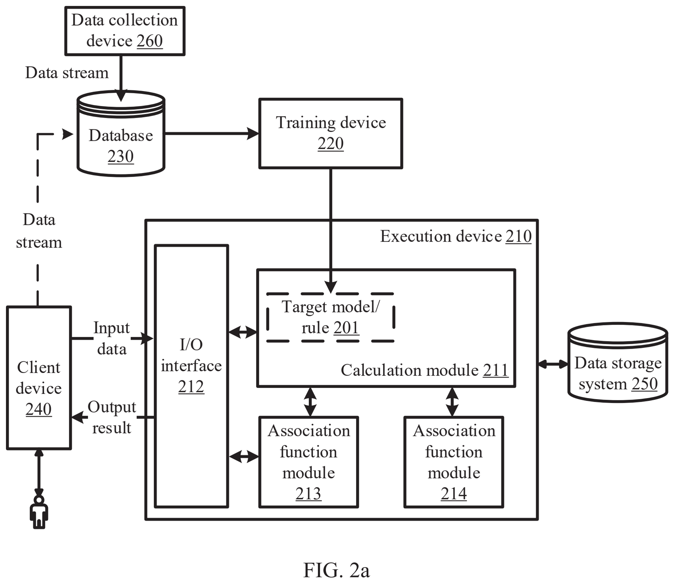

A first model in embodiments of this application is obtained through training based on a prior data pair. FIG. 2a is a diagram of an architecture of a model training system according to an embodiment of this application. A data collection device 260 is configured to collect, for example, image data and store the image data in a database 230, and a training device 220 generates a target model/rule 201 based on the image data maintained in the database 230.

Work at each layer of a deep neural network may be described by using a mathematical expression $y=a(Wgx+b)$. From a physical perspective, the work at each layer of the deep neural network may be understood as completing transformation from input space (a set of input vectors) to output space (in other words, from row space to column space of a matrix) by performing five types of operations on the input space. The five types of operations include: 1. dimension increase/dimension reduction; 2. scaling up/scaling down; 3. rotation; 4. translation; and 5. "bending". The operations 1, 2, and 3 are completed by Wgx, the operation 4 is completed by $+b$, and the operation 5 is completed by $a()$. The word "space" is used herein for expression because a classified object is not a single thing, but a type of thing. Space is a set of all individuals of this type of thing. *W* is a weight vector, and each value in the vector represents a weight value of one neuron at this layer of the neural network. The vector W determines space transformation from the input space to the output space described above. In other words, a weight *W* at each layer controls how to transform space. A purpose of training the deep neural network is to finally obtain a weight matrix (a weight matrix formed by vectors *W* at a plurality of layers) at all layers of a trained neural network. Therefore, a training process of the neural network is essentially a manner of learning control of the space transformation, and more specifically, learning the weight matrix.

Because it is expected that an output of the deep neural network is close, to a greatest extent, to a value that is actually expected to be predicted, a current predicted value of the network may be compared with a target value that is actually expected, and then a weight vector of each layer of the neural network is updated based on a difference between the current predicted value and the target value (certainly, there is usually an initialization process before first update, that is, a parameter is preconfigured for each layer of the deep neural network). For example, if the predicted value of the network is large, the weight vector is adjusted to decrease the predicted value. Adjustment is continuously performed, until the neural network can predict the target value that is actually expected. Therefore, "how to obtain, through comparison, the difference between the predicted value and the target value" needs to be predefined. This is a loss function (loss function) or an objective function (objective function). The loss function and the objective function are important equations that measure the difference between the predicted value and the target value. The loss function is used as an example. A higher output value (loss) of the loss function indicates a larger difference. Therefore, training of the deep neural network is a process of minimizing the loss as much as possible.

The target model/rule obtained by the training device 220 may be applied to different systems or devices. In FIG. 2a, an I/O interface 212 is configured for an execution device 210, to exchange data with an external device. A "user" may input data to the I/O interface 212 by using the client device 240.

The execution device 210 may invoke data, code, and the like in a data storage system 250, or may store data, instructions, and the like in the data storage system 250.

A calculation module 211 processes input data based on the target model/rule 201.

An association function module 213 is configured to extract a feature of received data, and perform a normalization operation.

The association function module 214 is configured to process a result output by the calculation module.

Finally, the I/O interface 212 returns a processing result to the client device 240 and provides the processing result for the user.

Further, the training device 220 may generate a corresponding target model/rule 201 based on different data for different targets, to provide a better result for the user.

In a case shown in FIG. 2a, the user may manually specify data to be input to the execution device 210, for example, by operating in an interface provided by the I/O interface 212. In another case, the client device 240 may automatically input data to the I/O interface 212 and obtain a result. If the client device 240 needs to obtain authorization from the user to automatically input the data, the user may set corresponding permission in the client device 240. The user may view, on the client device 240, the result output by the execution device 210. The result may be specifically presented in a specific manner of displaying, sound, action, or the like. The client device 240 may alternatively be used as a data collection end to store the collected image data in the database 230.

It should be noted that, FIG. 2a is merely a diagram of a system architecture according to an embodiment of the present invention. A position relationship between devices, components, modules, and the like shown in the figure does not constitute any limitation. For example, in FIG. 2a, the data storage system 250 is an external memory relative to the execution device 210, and in another case, the data storage system 250 may alternatively be disposed in the execution device 210.

The following uses an example in which a convolutional neural network performs training for description.

The convolutional neural network (CNN, Convolutional neuron network) is a deep neural network with a convolutional structure, and is a deep learning (deep learning) architecture. The deep learning architecture means that multi-layer learning is performed at different abstract levels according to a machine learning algorithm. As a deep learning architecture, the CNN is a feed-forward (feed-forward) artificial neural network, and each neuron in the feed-forward artificial neural network responds to an overlapping area in images input to the neuron.

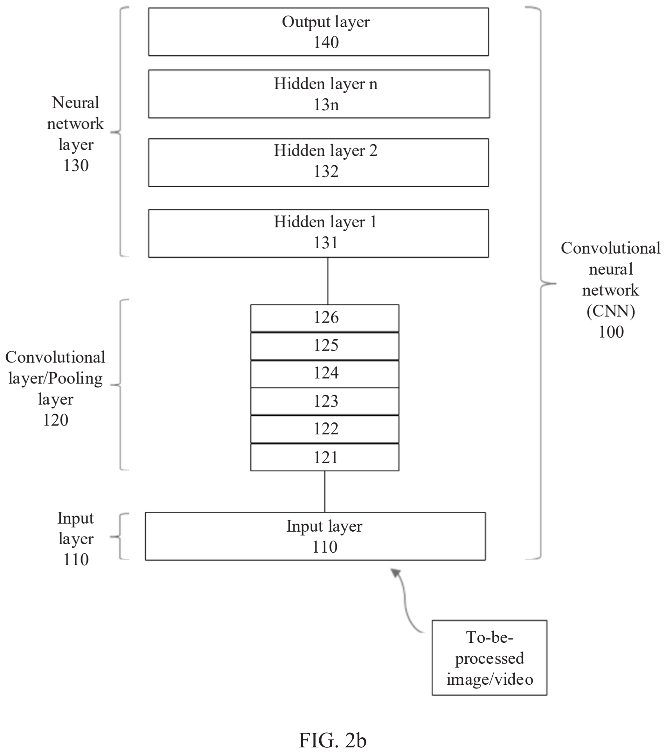

As shown in FIG. 2b, a convolutional neural network (CNN) 100 may include an input layer 110, a convolutional layer/pooling layer 120, where the pooling layer is optional, and a neural network layer 130.

Convolutional layer/Pooling layer 120:

Convolutional layer:

As shown in FIG. 2b, the convolutional layer/pooling layer 120 may include, for example, layers 121 to 126. In an implementation, the layer 121 is a convolutional layer, a layer 122 is a pooling layer, a layer 123 is a convolutional layer, a layer 124 is a pooling layer, a layer 125 is a convolutional layer, and the layer 126 is a pooling layer. In another implementation, the layers 121 and 122 are convolutional layers, the layer 123 is a pooling layer, the layers 124 and 125 are convolutional layers, and the layer 126 is a pooling layer. In other words, an output of a convolutional layer may be used as an input of a subsequent pooling layer, or may be used as an input of another convolutional layer to continue a convolution operation.

The convolutional layer 121 is used as an example. The convolutional layer 121 may include a plurality of convolution operators. A convolution operator is also referred to as a kernel. In image processing, the convolution operator functions as a filter that extracts specific information from an input image matrix. The convolution operator may be essentially a weight matrix, and the weight matrix is usually predefined. In a process of performing a convolution operation on an image, the weight matrix is usually used to process pixels at a granularity level of one pixel (or two pixels or the like, which depends on a value of a stride (stride)) in a horizontal direction on the input image, to extract a specific feature from the image.

A size of the weight matrix should be related to a size of the image. It should be noted that a depth dimension (depth dimension) of the weight matrix is the same as a depth dimension of the input image. During a convolution operation, the weight matrix extends to an entire depth of the input image. Therefore, a convolution output of a single depth dimension is generated by performing convolution with a single weight matrix. However, in most cases, a plurality of weight matrices of a same dimension rather than a single weight matrix are applied. Outputs of the weight matrices are stacked to form a depth dimension of a convolutional image.

Different weight matrices may be used to extract different features of the image. For example, one weight matrix is used to extract edge information of the image, another weight matrix is used to extract a specific color of the image, still another weight matrix is used to blur an unnecessary noise in the image, and so on. Because the plurality of weight matrices have the same dimension, feature maps extracted by using the plurality of weight matrices with the same dimension also have a same dimension. Then, the plurality of extracted feature maps with the same dimension are combined to form an output of the convolution operation.

Weight values in these weight matrices need to be obtained during actual application through massive training. The weight matrices that are formed based on the weight values obtained through training may be used to extract information from the input image, to help the convolutional neural network 100 perform correct prediction.

When the convolutional neural network 100 includes a plurality of convolutional layers, a large quantity of general features are usually extracted at an initial convolutional layer (for example, the convolutional layer 121). The general feature may be also referred to as a low-level feature. As a depth of the convolutional neural network 100 increases, a feature extracted at a more subsequent convolutional layer (for example, the convolutional layer 126) is more complex, for example, a high-level semantic feature. A feature with higher semantics is more applicable to a to-be-resolved problem.

Pooling layer:

Because a quantity of training parameters often needs to be reduced, a pooling layer often needs to be periodically introduced after a convolutional layer. For the layers 121 to 126 exemplified by 120 in FIG. 2b, one convolutional layer may be followed by one pooling layer, or a plurality of convolutional layers may be followed by one or more pooling layers. During image processing, the pooling layer is only used to reduce a space size of the image. The pooling layer may include an average pooling operator and/or a maximum pooling operator, to perform sampling on the input image to obtain an image with a small size. The average pooling operator may be used to calculate pixel values in the image in a specific range, to generate an average value. The maximum pooling operator may be used to select a pixel with a maximum value in a specific range as a maximum pooling result.

In addition, similar to that a size of a weight matrix at a convolutional layer needs to be related to a size of an image, an operator at the pooling layer also needs to be related to a size of an image. A size of an image output after processing at the pooling layer may be less than a size of an image input to the pooling layer. Each pixel in the image output from the pooling layer represents an average value or a maximum value of a corresponding sub-area of the image input to the pooling layer.

Neural network layer 130:

After processing is performed at the convolutional layer/pooling layer 120, the convolutional neural network 100 still cannot output required output information. This is because as described above, at the convolutional layer/pooling layer 120, only a feature is extracted, and parameters resulting from the input image are reduced. However, to generate final output information (required class information or other related information), the convolutional neural network 100 needs to use the neural network layer 130 to generate one or a group of outputs of a quantity of required classes.

Therefore, the neural network layer 130 may include a plurality of hidden layers (for example, layers 131, 132, ..., and 13n shown in FIG. 2b) and an output layer 140. Parameters included in the plurality of hidden layers may be obtained through pre-training based on related training data of a specific task type. For example, the task type may include image recognition, image classification, and super-resolution image reconstruction.

The plurality of hidden layers in the neural network layer 130 are followed by the output layer 140, namely, the last layer of the entire convolutional neural network 100. The output layer 140 has a loss function value similar to classification cross entropy, and the loss function value is specifically used to calculate a prediction error. Once forward propagation (for example, propagation from the layer 110 to the layer 140 in FIG. 2b is forward propagation) of the entire convolutional neural network 100 is completed, back propagation (for example, propagation from the layer 140 to the layer 110 in FIG. 2b is back propagation) is started to update weight values and deviations of the layers mentioned above, to reduce a loss of the convolutional neural network 100 and an error between a result output by the convolutional neural network 100 through the output layer and an ideal result.

It should be noted that the convolutional neural network 100 shown in FIG. 2b is merely used as an example of the convolutional neural network. During specific application, the convolutional neural network may alternatively exist in a form of another network model, for example, a plurality of parallel convolutional layers/pooling layers, and extracted features are all input to the neural network layer 130 for processing.

The foregoing describes the architecture for embodiments of this application. The following describes the method in embodiments of this application in detail.

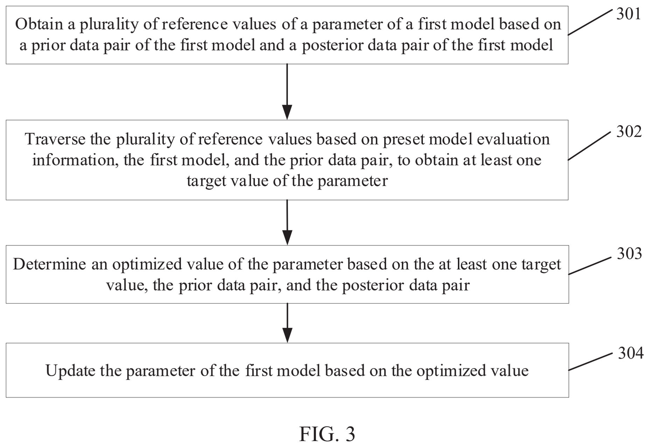

FIG. 3 is a schematic flowchart of a model parameter optimization method according to an embodiment of this application. Optionally, the method may be applied to the foregoing model parameter optimization system. The model parameter optimization method shown in FIG. 3 may include steps 301 to 304. It should be understood that, for ease of description in this application, a sequence of 301 to 304 is used for description, but this is not intended to limit execution necessarily performed in the sequence. An execution order, execution time, a quantity of execution times, and the like of the foregoing one or more steps are not limited in embodiments of this application. The following uses an example in which steps 301 to 304 in the model parameter optimization method are performed by a server for description. This application is also applicable to other execution bodies such as a client. Steps 301 to 304 are specifically as follows.

301: Obtain a plurality of reference values of a parameter of a first model based on a prior data pair of the first model and a posterior data pair of the first model.

The first model may be a trained model. The first model may be, for example, a convolutional neural network CNN model. This is not limited in this solution.

The prior data pair of the first model may be understood as training a model based on the prior data pair to obtain the first model. The prior data pair may include training data and a label corresponding to the training data.

Optionally, the prior data pair may include data pairs of a plurality of different training data domains. The data domain may be understood as a data set formed by data sampled from a data distribution, and data sampled from different data distributions forms different data domains.

The posterior data pair of the first model may be understood as a data pair used in a process of optimizing the parameter of the trained first model. Alternatively, the posterior data pair of the first model may be a data pair used during commercial use, or the like. This is not limited in this solution.

The parameter of the first model may be all parameters or a part of parameters. When the parameter is all parameters of the model, for example, the first model has three parameters: $w1$, $w2$, and $w3$, the plurality of reference values may be, for example, ($w1=2$, $w2=3$, $w3=0.5$), ($w1=0.2$, $w2=2$, $w3=0.4$), ($w1=0.2$, $w2=0.4$, $w3=1.3$), and so on. When the parameter is a part of parameters of the model, for example, the parameter is a parameter $w2$ of the first model, the plurality of reference values may be, for example, $w2=3$, $w2=2$, $w2=0.4$, and the like. This is not limited in this solution.

In a possible implementation, the plurality of reference values of the parameter of the first model may be obtained based on a Monte Carlo sampling method, the prior data pair of the first model, and the posterior data pair of the first model. The Monte Carlo sampling method is a random simulation method. The following describes a method for obtaining one of the reference values. A Langevin Monte Carlo sampling method is a classic Markov chain Monte Carlo sampling method. The Langevin Monte Carlo sampling method samples a reference value from parameter space based on a prior distribution probability, calculates a gradient of posterior data on the reference value, and searches for a next reference value of the parameter of the first model in a direction of a negative gradient. To ensure a specific level of randomness, a specific amount of Gaussian noise is superimposed on the reference value obtained from the search. A maximum stride that meets a preset constraint (preset model evaluation information described below) is selected as an iteration stride for the search. Subsequently, cyclic iteration is performed based on the previous step until the reference value is converged (a variation is less than a specific preset value for a plurality of consecutive search times), thereby obtaining the reference value.

Certainly, the reference value may alternatively be obtained in another manner. This is not limited in this solution.

302: Traverse the plurality of reference values based on the preset model evaluation information, the first model, and the prior data pair, to obtain at least one target value of the parameter, where a loss value that is of a model on the prior data pair and that corresponds to the target value is not greater than an upper bound of a loss value of a model in the preset model evaluation information, and/or a test accuracy value that is of the model on the prior data pair and that corresponds to the target value is not less than a lower bound of a test accuracy value of the model in the preset model evaluation information.

The preset model evaluation information may include the upper bound of the loss value of the model and/or the lower bound of the test accuracy value of the model. Certainly, the preset model evaluation information may alternatively be other evaluation information. This is not limited in this solution.

Based on the preset model evaluation information, a proper parameter of the model is selected, so that performance of the model can be ensured.

The at least one target value of the parameter may be obtained through traversing of the plurality of reference values and selection from the plurality of reference values, or may be obtained by processing the reference values. This is not limited in this solution.

The loss value that is of the model on the prior data pair and that corresponds to the target value is not greater than the upper bound of the loss value of the model in the preset model evaluation information, and/or the test accuracy value that is of the model and that corresponds to the target value is not less than the lower bound of the test accuracy value of the model in the preset model evaluation information. It may be understood that model evaluation information corresponding to the target value meets a requirement of the preset model evaluation information.

For example, an average loss value that is of the model in each training data domain and that corresponds to each reference value may be solved (for example, for a training data domain A, a loss value of each prior data pair in the training data domain A is calculated, and then an average value of the loss values of the prior data pairs in the training data domain A is solved based on a quantity of prior data pairs in the training data domain A), and then a training data domain with a greatest average loss value is obtained. If a loss value of the training data domain with the greatest average loss value is not less than the upper bound of the loss value of the model in the preset model evaluation information, this reference value is denoted as the target value. If a loss value of the training data domain with the greatest average loss value is greater than the upper bound of the loss value of the model in the preset model evaluation information, this reference value is discarded.

The foregoing steps are repeated, to traverse and search the plurality of reference values, so that the at least one target value can be obtained.

For a manner of determining the target value based on the test accuracy value, refer to the foregoing descriptions, and details are not described herein again.

In a possible implementation, based on the plurality of reference values of the parameter, the target value of the parameter may be determined from the plurality of reference values based on the following expression:

$$\theta: \max \mathrm{L}_{tr}(f\theta) \leq \rho 1 + \varepsilon_{n1}$$

$\theta$ represents the parameter of the first model. $\mathrm{L}_{tr}(f\theta)$ represents a loss value corresponding to a prior data pair tr of a model. $\rho 1$ represents a preset upper bound of a loss value of a model, and $\varepsilon_{n1}$ represents a fluctuation value of a loss value of a model in a training data domain n1, where the training data domain n1 is a data domain with a greatest loss value in a plurality of training data domains corresponding to the prior data pair.

For example, taking each training data domain as a unit, loss values of prior data pairs tr in each training data domain are separately calculated, and then an average value of the loss values in each training data domain is calculated, to determine a greatest loss value max $\mathrm{L}_{tr}(f\theta)$ based on the average values. If the greatest loss value is not greater than $\rho 1$ + $\varepsilon_{n1}$, $\theta$ is determined as a target value.

In this example, an example in which the loss values corresponding to the prior data pairs tr of the model in each training data domain are not greater than $\rho 1$ + $\varepsilon_{n1}$ is used for description. Certainly, all the loss values corresponding to the prior data pair of the model may alternatively not be greater than $\rho 1$, or the like. There may alternatively be another setting. This is not limited in this solution.

In another possible implementation, the target value of the parameter may be determined based on the following expression:

$$\theta: \min \mathrm{L}_{tr}(f\theta) \geq \rho 2 + \varepsilon_{n2}$$

$\theta$ represents the parameter of the first model. $\mathrm{L}_{tr}(f\theta)$ represents a loss value of a model on a prior data pair tr. $\rho 2$ represents a lower bound of a test accuracy value of a model, and $\varepsilon_{n2}$ represents a fluctuation value of a test accuracy value of a model in a training data domain n2, where the training data domain n2 is a data domain with a smallest test accuracy value in a plurality of training data domains corresponding to the prior data pair.

That is, a test accuracy value corresponding to the prior data pair tr of the model in each training data domain is not less than $\rho 2$ + $\varepsilon_{n2}$.

The foregoing two implementations may alternatively be used in combination. This is not limited in this solution.

In the foregoing examples, the loss value of the model and the test accuracy value of the model are merely used as examples for description. There may alternatively be another evaluation criterion, for example, an average mean-square error between a test value of the model and a label.

303: Determine an optimized value of the parameter based on the at least one target value, the prior data pair, and the posterior data pair.

The optimized value of the parameter is determined based on the determined target value of the parameter, and the prior data pair and the posterior data pair of the first model.

In a possible implementation, step 303 may include steps 3031 to 3034, which are specifically as follows.

3031: Obtain a prior distribution of the parameter based on the prior data pair.

The prior distribution of the parameter of the first model may be understood as a probability distribution of the parameter.

Optionally, a distribution of a plurality of parameters obtained in a model training process is processed based on the prior data pair, to obtain a point distribution and the like and further obtain the prior distribution of the parameter.

Certainly, another manner may alternatively be used. For example, the prior distribution of the parameter may be manually specified. This is not limited in this solution.

3032: Obtain a loss value of the first model on the posterior data pair based on the posterior data pair and the at least one target value.

Based on the target value of the parameter of the first model, the posterior data pair is input to the first model corresponding to the target value, so that a loss value corresponding to each posterior data pair can be obtained.

3033: Obtain a posterior distribution of the parameter based on the prior distribution of the parameter and the loss value of the first model on the posterior data pair.

In a possible implementation, the posterior distribution of the parameter may be expressed as:

$$\mathrm{p}(d\theta | D_{tr}, D_{ad}) \propto \pi(d\theta) \prod_{i=1}^{n^*} e^{-l\left(yi^*, f\theta(xi^*)\right)}$$

$\mathrm{p}(d\theta | D_{tr}, D_{ad})$ represents the posterior distribution of the parameter $\theta$, $\pi(d\theta)$ represents the prior distribution of the parameter $\theta$, $(xi^*, yi^*)$ represents an $i^{th}$ data pair in the posterior data pair ad, $n^*$ represents a quantity of posterior data pairs, and $l$ represents a loss value of the first model on the posterior data pair $(xi^*, yi^*)$.

In other words, the posterior distribution of the parameter is related to the prior distribution of the parameter and the model loss value corresponding to the posterior data pair. This can avoid a defect of poor model performance caused by a large data amount difference resulted from a large quantity of prior data pairs and small-sample posterior data pairs.

3034: Determine the optimized value of the parameter based on the posterior distribution of the parameter.

In a possible implementation, a value that is of the parameter and that corresponds to a maximum probability in the posterior distribution of the parameter is determined as the optimized value of the parameter. In this way, the obtained optimized value of the parameter is optimal on the posterior data pair.

In another possible implementation, sampling is performed based on the posterior distribution of the parameter to obtain a plurality of values of the parameter, and weighted averaging processing is performed on the plurality of values of the parameter to obtain the optimized value of the parameter. The sampling may be, for example, probability-based sampling. The weighted averaging processing may be, for example, performing weighted averaging by using a probability value as a weight. Through this example, uncertainty estimation of a prediction result of the model can be implemented.

There may alternatively be another solving manner. This is not limited in this solution.

It should be noted that, in this embodiment of this application, the foregoing expression is merely used as an example for description, and there may alternatively be another representation. For example, the optimized value of the parameter may be determined in step 302 and step 303 in the following manner:

$$\mathrm{p}(d\theta | D_{tr}, D_{ad}) \propto \pi(d\theta) 1_{\theta \in C_{tr}} \prod_{i=1}^{n^*} e^{-l\left(yi^*, f\theta(xi^*)\right)}$$

$C_{tr} := \{\theta: \max L_{tr}(f\theta) \leq \rho1 + \varepsilon_{n1}\}$, and/or $C_{tr} := \{\theta: \min L_{tr}(f\theta) \geq \rho2 + \varepsilon_{n2}\}$.

In other words, when $\theta$ meets the foregoing restrictive condition, the posterior distribution p of the parameter is in direct proportion to the prior distribution $\pi(d\theta)$ of the parameter and the model loss value corresponding to the posterior data pair. If $\theta$ does not meet the foregoing restrictive condition, a value of the posterior distribution p of the parameter is, for example, 0.

304: Update the parameter of the first model based on the optimized value.

The first model is updated based on the determined optimized value of the parameter, to obtain an optimized first model. In this way, the model can take both the prior data pair and the posterior data pair into consideration. In addition, the posterior distribution of the parameter of the model is not affected by a quantity of prior data pairs, so that performance is better.

The parameter of the first model may be continuously updated based on re-obtained posterior data pair until model accuracy, performance, and the like meet a criterion.

Optionally, the obtained posterior data pair may be further provided for a model training apparatus. In this way, the model training apparatus can use the posterior data pair as a prior data pair, so that more data is accumulated in a subsequent training process, which allows for gradual evolution of an algorithm.

In this embodiment of this application, based on the plurality of reference values of the parameter of the first model, the plurality of reference values are traversed based on the preset model evaluation information and the prior data pair, to obtain the at least one target value of the parameter, and then the optimized value of the parameter is determined based on the target value and the prior data pair and the posterior data pair of the first model, to update the first model based on the optimized value. In this manner, the loss value that is of the model on the prior data pair and that corresponds to the target value of the parameter is not greater than the upper bound of the loss value of the model, and/or the test accuracy value that is of the model on the prior data pair and that corresponds to the target value is not less than the lower bound of the test accuracy value of the model, so that the obtained optimized value of the parameter can guarantee the prior data pair at the same time. The optimized value of the parameter is determined based on the target value and the prior data pair and the posterior data pair of the first model, so that it is ensured that the optimized value of the parameter can take the posterior data pair into consideration, and performance is better.

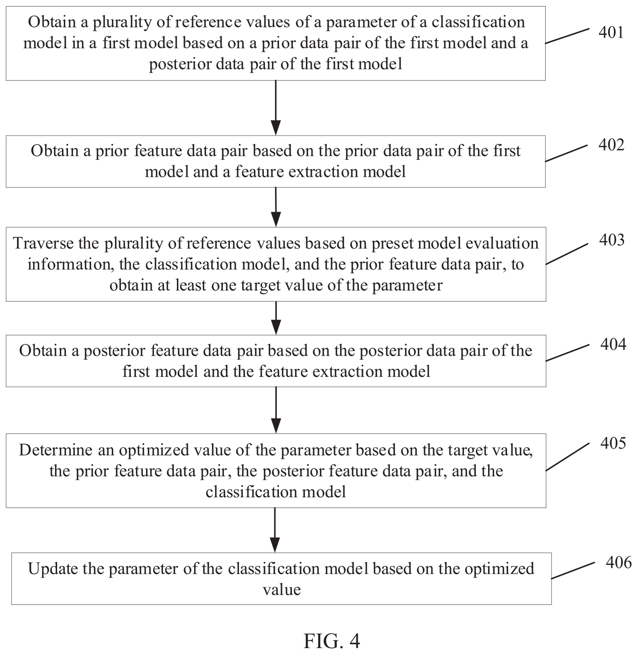

The following describes the foregoing model parameter optimization method by using an example in which a part of parameters of the model are updated as shown in FIG. 4. The first model sequentially includes a feature extraction model and a classification model, and the part of parameters are parameters corresponding to the classification model. Specifically, FIG. 4 is a schematic flowchart of another model parameter optimization method according to an embodiment of this application. Optionally, the method may be applied to the foregoing model parameter optimization system. The model parameter optimization method shown in FIG. 4 may include steps 401 to 406. It should be understood that, for ease of description in this application, a sequence of 401 to 406 is used for description, but this is not intended to limit execution necessarily performed in the sequence. An execution order, execution time, a quantity of execution times, and the like of the foregoing one or more steps are not limited in embodiments of this application. The following uses an example in which steps 401 to 406 in the model parameter optimization method are performed by a server for description. This application is also applicable to other execution bodies such as a client. Steps 401 to 406 are specifically as follows.

401: Obtain a plurality of reference values of a parameter of a classification model in a first model based on a prior data pair of the first model and a posterior data pair of the first model.

In this example, an example in which a part of parameters (the parameter of the classification model) in the first model are updated is used for description. Certainly, a parameter of a feature extraction model may alternatively be updated. This is not limited in this solution.

For descriptions of this part, refer to the descriptions of step 301 in the embodiment shown in FIG. 3. Details are not described herein again.

402: Obtain a prior feature data pair based on the prior data pair of the first model and the feature extraction model.

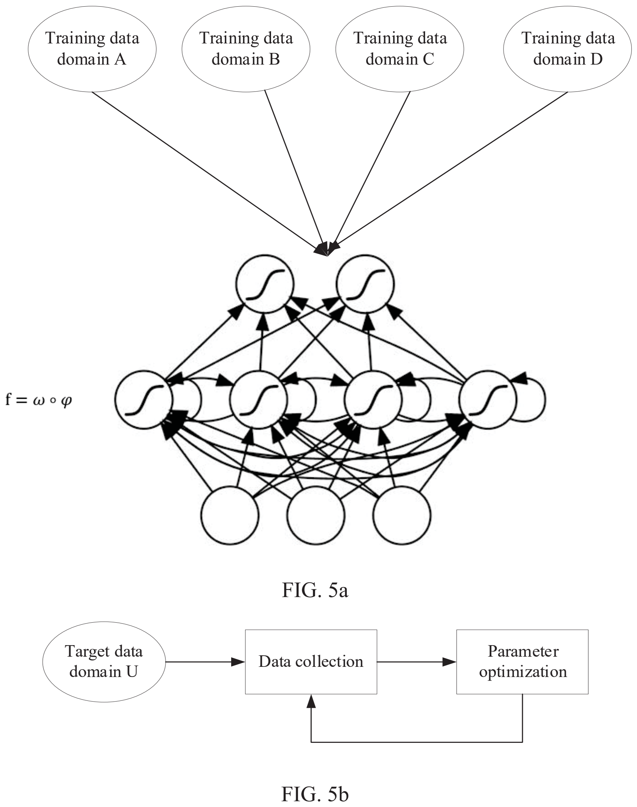

The first model is obtained through training based on the prior data pair. As shown in FIG. 5a, training is performed based on a plurality of training data domains, to obtain a first model f, where the first model f may be expressed as a composite of two functions (models): $f=\omega\circ\varphi$, where $\varphi$ is a model feature extraction part and $\omega$ is a model classification part.

For example, an initial model is trained based on four training data domains A, B, C, and D, to obtain the first model. The first model includes the feature extraction part $\varphi$, and the feature extraction part is used to extract an embedded feature $\varphi(x)$ of data. The first model further includes a classification part (for example, a classifier), and the classification part corresponds to a parameter $\theta$ (in this case, $\omega$ is $\theta$). Even sampling may be performed on the four training data domains. For example, 1000 data pairs are sampled in each training data domain to perform model training.

Optionally, training data (for example, x) in the prior data pair (for example, (x, y)) of the first model is input to the feature extraction model for feature extraction processing, to obtain prior feature data (for example, $\varphi(x)$), and a prior feature data pair ($\varphi(x)$, y) may be obtained with reference to a label (for example, y) of the prior data pair.

403: Traverse the plurality of reference values based on preset model evaluation information, the classification model, and the prior feature data pair, to obtain at least one target value of the parameter, where a loss value that is of a classification model and that corresponds to the target value is not greater than an upper bound of a loss value of a classification model on the prior feature data pair in the preset model evaluation information, and/or a test accuracy value that is of the classification model on the prior feature data pair and that corresponds to the target value is not less than a lower bound of a test accuracy value of the classification model in the preset model evaluation information.

In a possible implementation, based on the plurality of reference values of the parameter, the target value of the parameter may be determined based on the following expression:

$$\theta\colon \max \mathrm{L}_{tr}(f\theta) \leq \rho 1 + \varepsilon_{n1}$$

$\theta$ represents the parameter of the classification model. $\mathrm{L}_{tr}(f\theta)$ represents a loss value of a classification model on a prior data pair tr. $\rho 1$ represents an upper bound of a loss value of a classification model, and $\varepsilon_{n1}$ represents a fluctuation value of a loss value of a classification model in a training data domain n1, where the training data domain n1 is a data domain with a greatest loss value in a plurality of training data domains corresponding to the prior feature data pair.

That is, a loss value corresponding to each training data domain corresponding to the prior feature data pair of the classification model is not greater than $\rho 1 + \varepsilon_{n1}$.

In another possible implementation, the target value of the parameter may be determined based on the following expression:

$$\theta\colon \min \mathrm{L}_{tr}(f\theta) \geq \rho 2 + \varepsilon_{n2}$$

$\theta$ represents a parameter of the classification model. $\mathrm{L}_{tr}(f\theta)$ represents a loss value of a classification model on the prior data pair tr. $\rho 2$ represents a lower bound of the test accuracy value of a classification model, and $\varepsilon_{n2}$ represents a fluctuation value of a test accuracy value of a classification model in a training data domain n2, where the training data domain n2 is a data domain with a smallest test accuracy value in a plurality of training data domains corresponding to the prior feature data pair.

That is, a test accuracy value corresponding to the prior data pair tr of the classification model in each training data domain is not less than $\rho 2 + \varepsilon_{n2}$.

The foregoing two implementations may alternatively be used in combination. This is not limited in this solution.

For descriptions of this step, refer to the descriptions of step 302 in the embodiment shown in FIG. 3. Details are not described herein again.

This example allows for storing only the prior feature data pair. Compared with directly storing the prior data pair, this solution can reduce a data storage amount.

404: Obtain a posterior feature data pair based on the posterior data pair of the first model and the feature extraction model.

Optionally, training data in the posterior data pair of the first model is input to the feature extraction model for feature extraction processing, to obtain posterior feature data, and a posterior feature data pair may be obtained with reference to a label of the posterior data pair.

405: Determine an optimized value of the parameter based on the target value, the prior feature data pair, the posterior feature data pair, and the classification model.

In a possible implementation, step 405 may include steps 4051 to 4054, which are specifically as follows.

4051: Obtain a prior distribution of the parameter of the classification model based on the prior feature data pair.

Optionally, the prior distribution of the parameter may be obtained based on a plurality of $\theta$ obtained in a training process of the classification model in the first model.

Certainly, another manner may alternatively be used. This is not limited in this solution.

4052: Obtain a loss value of the classification model on the posterior feature data pair based on the posterior feature data pair and the target value.

Based on the at least one target value, posterior feature data in the posterior feature data pair is input to the classification model corresponding to the target value, to obtain classification data, and a loss value corresponding to each posterior feature data pair may be obtained with reference to the label of the posterior feature data pair.

4053: Obtain a posterior distribution of the parameter based on the prior distribution of the parameter and the loss value of the classification model on the posterior feature data pair.

In a possible implementation, the posterior distribution of the parameter may be expressed as:

$$\mathrm{p}(d\theta | D_{tr}, D_{ad}) \propto \pi(d\theta) \prod_{i=1}^{n^*} e^{-l\left(yi^*, f\theta(xi^*)\right)}$$

$\mathrm{p}(d\theta | D_{tr}, D_{ad})$ represents the posterior distribution of the parameter $\theta$, $\pi(d\theta)$ represents the prior distribution of the parameter $\theta$, $(xi^*, yi^*)$ is an $i^{th}$ data pair in the posterior feature data pair, and $n^*$ represents a quantity of posterior feature data pairs.

In other words, the posterior distribution of the parameter is related to the prior distribution of the parameter and the model loss value corresponding to the posterior feature data pair. This can avoid a defect of poor model performance caused by a large data amount difference resulted from a large quantity of prior data pairs and small-sample posterior data pairs.

4054: Determine the optimized value of the parameter based on the posterior distribution of the parameter.

For descriptions of this step, refer to the descriptions of step 3034 in the embodiment shown in FIG. 3. Details are not described herein again.

406: Update the parameter of the classification model based on the optimized value.

As shown in FIG. 5b, model parameter optimization is performed based on a target data domain U corresponding to an actual application scenario. The classification model is updated based on the determined optimized value of the parameter, to obtain an optimized classification model, so that an optimized first model can be obtained. In this process, the feature extraction model may not be updated. Based on the foregoing parameter optimization processing, the first model can take both the prior data pair and the posterior data pair into consideration. In addition, the posterior distribution of the parameter of the model is not affected by a quantity of prior data pairs, so that performance is better.

It should be noted that, in embodiments of this application, unless otherwise stated or there is a logic conflict, terms and/or descriptions between embodiments are consistent and may be mutually referenced, and technical features in different embodiments may be combined into a new embodiment based on an internal logical relationship thereof.

The method in embodiments of this application is described in detail above. The apparatus in embodiments of this application is provided below. It may be understood that, in apparatus embodiments of this application, division into a plurality of units or modules is merely logical division based on functions, and is not intended to limit a specific structure of the apparatus. During specific implementation, some function modules may be subdivided into more function modules that are smaller, and some function modules may alternatively be combined into one function module. However, regardless of whether these function modules are subdivided or combined, a general procedure performed by the apparatus is the same. For example, some apparatuses include a receiving unit and a sending unit. In some designs, the sending unit and the receiving unit may alternatively be integrated into a communication unit, and the communication unit may implement functions implemented by the receiving unit and the sending unit. Usually, each unit corresponds to respective program code (or program instructions). When the program code corresponding to the unit is run on a processor, the unit is controlled by a processing unit to perform a corresponding procedure to implement a corresponding function.

An embodiment of this application further provides an apparatus for implementing any one of the foregoing methods. For example, a model parameter optimization apparatus is provided, including modules (or means) configured to implement steps performed by a server (or a client) in any one of the foregoing methods.

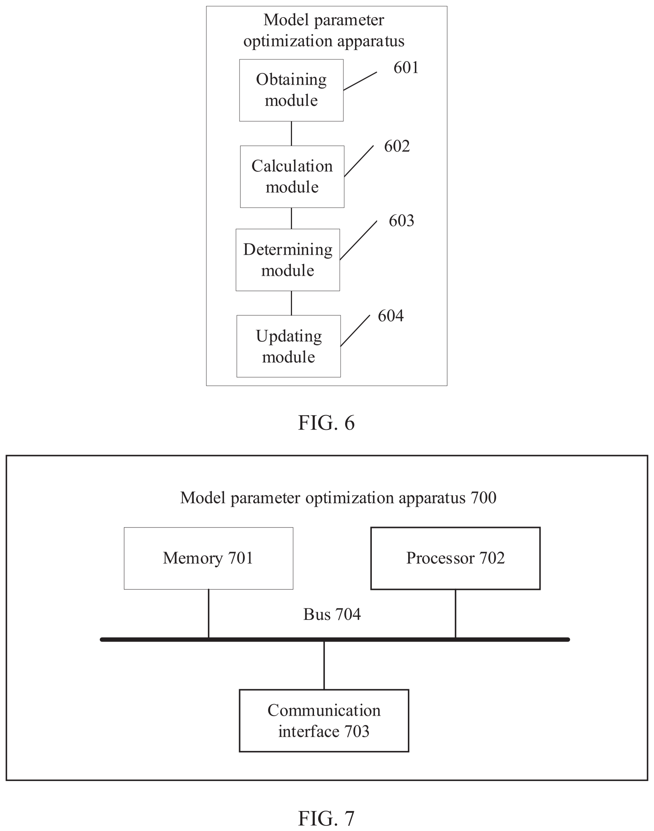

For example, FIG. 6 is a diagram of a structure of a model parameter optimization apparatus according to an embodiment of this application. The model parameter optimization apparatus is configured to implement the foregoing model parameter optimization method, for example, the model parameter optimization methods shown in FIG. 3 and FIG. 4.

As shown in FIG. 6, the apparatus may include an obtaining module 601, a calculation module 602, a determining module 603, and an updating module 604, which are specifically as follows.

The obtaining module 601 is configured to obtain a plurality of reference values of a parameter of a first model based on a prior data pair of the first model and a posterior data pair of the first model.

The calculation module 602 is configured to traverse the plurality of reference values based on preset model evaluation information, the first model, and the prior data pair of the first model, to obtain at least one target value of the parameter, where a loss value that is of a model on the prior data pair and that corresponds to the target value is not greater than an upper bound of a loss value of a model on the prior data pair in the preset model evaluation information, and/or a test accuracy value that is of the model on the prior data pair and that corresponds to the target value is not less than a lower bound of a test accuracy value of the model on the prior data pair in the preset model evaluation information.

The determining module 603 is configured to determine an optimized value of the parameter based on the at least one target value, the prior data pair of the first model, and the posterior data pair of the first model.

The updating module 604 is configured to update the parameter of the first model based on the optimized value.

In a possible implementation, the determining module 603 is configured to:

obtain a prior distribution of the parameter of the first model based on the prior data pair;
obtain a loss value of the first model on the posterior data pair based on the posterior data pair and the at least one target value;
obtain a posterior distribution of the parameter based on the prior distribution of the parameter and the loss value of the first model on the posterior data pair; and
determine the optimized value of the parameter based on the posterior distribution of the parameter.

In a possible implementation, a value that is of the parameter and that corresponds to a maximum probability in the posterior distribution of the parameter is determined as the optimized value of the parameter.

In a possible implementation, the determining module 603 is further configured to:

perform sampling based on the posterior distribution of the parameter to obtain a plurality of values of the parameter; and

perform weighted averaging processing on the plurality of values of the parameter, to obtain the optimized value of the parameter.

In a possible implementation, the parameter is all parameters of the first model.

In a possible implementation, the parameter is a part of parameters of the first model, the first model sequentially includes a feature extraction model and a classification model, and the part of parameters are parameters corresponding to the classification model.

The calculation module 602 is configured to:

obtain a prior feature data pair based on the prior data pair of the first model and the feature extraction model; and

traverse the plurality of reference values based on the preset model evaluation information, the classification model, and the prior feature data pair, to obtain the at least one target value of the parameter.

The determining module 603 is configured to:

obtain a posterior feature data pair based on the posterior data pair of the first model and the feature extraction model; and

determine the optimized value of the parameter based on the at least one target value, the prior feature data pair, the posterior feature data pair, and the classification model.

For descriptions of the foregoing modules, refer to the descriptions of the foregoing method embodiments, and details are not described herein again.

It should be understood that division into the modules in the foregoing apparatuses is merely logical function division. During actual implementation, all or some of the modules may be integrated into one physical entity, or may be physically separated. In addition, the module in the model parameter optimization apparatus may be implemented in a form of software invoked by a processor. For example, the model parameter optimization apparatus includes a processor. The processor is connected to a memory. The memory stores instructions. The processor invokes the instructions stored in the memory, to implement any one of the foregoing methods or implement functions of each module of the apparatus. The processor is, for example, a general-purpose processor, for example, a central processing unit (central processing unit, CPU) or a microprocessor. The memory is a memory inside the apparatus or a memory outside the apparatus. Alternatively, the module in the apparatus may be implemented in a form of hardware circuit, and functions of some or all units may be implemented by designing the hardware circuits. The hardware circuits may be understood as one or more processors. For example, in an implementation, the hardware circuit is an application-specific integrated circuit (application-specific integrated circuit, ASIC), and the functions of some or all of the foregoing units are implemented by designing a logical relationship between elements in the circuit. For another example, in another implementation, the hardware circuit may be implemented by using a programmable logic device (programmable logic device, PLD). A field programmable gate array (field programmable gate array, FPGA) is used as an example, and the field programmable gate array may include a large quantity of logic gate circuits. A configuration file is used to configure a connection relationship between logic gate circuits, to implement functions of some or all of the foregoing units. All the modules in the apparatus may be implemented in a form of software invoked by a processor, or all the modules may be implemented in a form of hardware circuit, or some modules may be implemented in a form of software invoked by a processor, and a remaining part may be implemented in a form of hardware circuit.

FIG. 7 is a diagram of a hardware structure of another model parameter optimization apparatus according to an embodiment of this application. The model parameter optimization apparatus 700 (where the apparatus 700 may be specifically a computer device) shown in FIG. 7 includes a memory 701, a processor 702, a communication interface 703, and a bus 704. A communication connection among the memory 701, the processor 702, and the communication interface 703 is implemented through the bus 704.

The memory 701 may be a read-only memory (read-only memory, ROM), a static storage device, a dynamic storage device, or a random access memory (random access memory, RAM).

The memory 701 may store a program. When the program stored in the memory 701 is executed by the processor 702, the processor 702 and the communication interface 703 are configured to perform the steps of the model parameter optimization method in embodiments of this application.

The processor 702 is a circuit having a signal processing capability. In an implementation, the processor 702 may be a circuit having an instruction reading and running capability, for example, a central processing unit CPU, a microprocessor, a graphics processing unit (graphics processing unit, GPU) (which may be understood as a microprocessor), or a digital signal processor (digital signal processor, DSP). In another implementation, the processor 702 may implement a specific function based on a logical relationship of a hardware circuit, and the logical relationship of the hardware circuit is fixed or reconfigurable. For example, the processor 702 is a hardware circuit implemented by an ASIC or a programmable logic device PLD, for example, an FPGA. In a reconfigurable hardware circuit, a process in which the processor loads a configuration document to implement hardware circuit configuration may be understood as a process in which the processor loads instructions to implement functions of some or all of the foregoing modules. In addition, the processor may alternatively be a hardware circuit designed for artificial intelligence, and may be understood as an ASIC, for example, a neural network processing unit (neural network processing unit, NPU), a tensor processing unit (tensor processing unit, TPU), or a deep learning processing unit (deep learning processing unit, DPU). The processor 702 is configured to execute a related program, to implement functions that need to be performed by the units in the model parameter optimization apparatus in embodiments of this application, or perform the model parameter optimization method in the method embodiments of this application.

It can be learned that each module in the foregoing apparatus may be one or more processors (or processing circuits) configured to implement the foregoing method, for example, a CPU, a GPU, an NPU, a TPU, a DPU, a microprocessor, a DSP, an ASIC, an FPGA, or a combination of at least two of these processor forms.

In addition, all or some of the modules in the foregoing apparatus may be integrated, or may be independently implemented. In an implementation, the modules are integrated and implemented in a form of system-on-a-chip (system-on-a-chip, SOC). The SOC may include at least one processor configured to implement any one of the foregoing methods or implement functions of the modules of the apparatus. Types of the at least one processor may be different, including, for example, a CPU and an FPGA, a CPU and an artificial intelligence processor, and a CPU and a GPU.

The communication interface 703 uses a transceiver apparatus, for example, but not limited to, a transceiver, to implement communication between the apparatus 700 and another device or a communication network. For example, data may be obtained through the communication interface 703.

The bus 704 may include a path for transferring information between the components (for example, the memory 701, the processor 702, and the communication interface 703) of the apparatus 700.

It should be noted that although the apparatus 700 shown in FIG. 7 only shows the memory, the processor, and the communication interface, in a specific implementation process, a person skilled in the art should understand that the apparatus 700 further includes other components that are necessary to implement normal running. In addition, according to a specific requirement, a person skilled in the art should understand that the apparatus 700 may further include hardware components for implementing other additional functions. In addition, a person skilled in the art should understand that the apparatus 700 may alternatively include only components necessary for implementing embodiments of this application, but does not need to include all the components shown in FIG. 7.

An embodiment of this application further provides a computer-readable storage medium. The computer-readable storage medium stores instructions, and when the instructions are run on a computer or a processor, the computer or the processor is enabled to perform one or more steps in any one of the foregoing methods.

An embodiment of this application further provides a computer program product including instructions. When the computer program product runs on a computer or a processor, the computer or the processor is enabled to perform one or more steps in any one of the foregoing methods.

It should be understood that unless otherwise specified, "/" in descriptions of this application indicates an "or" relationship between associated objects. For example, A/B may indicate A or B. A and B may be singular or plural. In addition, in the descriptions of this application, "a plurality of" means two or more than two unless otherwise specified. "At least one of the following items (pieces)" or a similar expression thereof means any combination of these items, including a singular item (piece) or any combination of plural items (pieces). For example, at least one item (piece) of a, b, or c may indicate: a, b, c, a and b, a and c, b and c, or a, b, and c, where a, b, and c may be singular or plural. In addition, to clearly describe the technical solutions in embodiments of this application, terms such as first and second are used in embodiments of this application to distinguish between same items or similar items that provide basically same functions or purposes. A person skilled in the art may understand that the terms such as "first" and "second" do not limit a quantity or an execution sequence, and the terms such as "first" and "second" do not indicate a definite difference. In addition, in embodiments of this application, terms such as "example" or "for example" are used to represent giving an example, an illustration, or a description. Any embodiment or design scheme described as an "example" or "for example" in embodiments of this application should not be explained as being more preferred or having more advantages than another embodiment or design scheme. Exactly, use of the terms such as "example" or "for example" is intended to present a related concept in a specific manner for ease of understanding.

In the several embodiments provided in this application, it should be understood that the disclosed system, apparatus, and method may be implemented in other manners. For example, division into the units is merely logical function division and may be another division during actual implementation. For example, a plurality of units or components may be combined or integrated into another system, or some features may be ignored or not performed. The displayed or discussed mutual couplings or direct couplings or communication connections may be implemented through some interfaces. The indirect couplings or communication connections between the apparatuses or units may be implemented in electronic, mechanical, or other forms.

The units described as separate parts may or may not be physically separate, and parts displayed as units may or may not be physical units, in other words, may be located in one position, or may be distributed on a plurality of network units. Some or all of the units may be selected according to actual requirements to achieve the objectives of the solutions of embodiments.

All or some of the foregoing embodiments may be implemented by using software, hardware, firmware, or any combination thereof. When software is used to implement embodiments, all or some of the embodiments may be implemented in a form of computer program product. The computer program product includes one or more computer instructions. When the computer program instructions are loaded and executed on a computer, all or some of the procedures or functions according to embodiments of this application are generated. The computer may be a general-purpose computer, a dedicated computer, a computer network, or another programmable apparatus. The computer instructions may be stored in a computer-readable storage medium, or may be transmitted by using the computer-readable storage medium. The computer instructions may be transmitted from a website, computer, server, or data center to another website, computer, server, or data center in a wired (for example, a coaxial cable, an optical fiber, or a digital subscriber line (digital subscriber line, DSL)) or wireless (for example, infrared, radio, or microwave) manner. The computer-readable storage medium may be any usable medium accessible by the computer, or a data storage device, for example, a server or a data center, integrating one or more usable media. The usable medium may be a read-only memory (read-only memory, ROM), a random access memory (random access memory, RAM), or a magnetic medium, for example, a floppy disk, a hard disk, a magnetic tape, a magnetic disk, or an optical medium, for example, a digital versatile disc (digital versatile disc, DVD), or a semiconductor medium, for example, a solid-state disk (solid-state disk, SSD).

The foregoing descriptions are merely specific implementations of embodiments of this application, but are not intended to limit the protection scope of embodiments of this application. Any variation or replacement within the technical scope disclosed in embodiments of this application shall fall within the protection scope of embodiments of this application. Therefore, the protection scope of embodiments of this application shall be subject to the protection scope of the claims.

**Claims**

1.    A model parameter optimization method, comprising:

obtaining a plurality of reference values of a parameter of a first model based on a prior data pair of the first model and a posterior data pair of the first model;
traversing the plurality of reference values based on preset model evaluation information, the first model, and the prior data pair, to obtain at least one target value of the parameter, wherein a loss value that is of a model on the prior data pair and that corresponds to the target value is not greater than an upper bound of a loss value of a model on the prior data pair in the preset model evaluation information, and/or a test accuracy value that is of the model on the prior data pair and that corresponds to the target value is not less than a lower bound of a test accuracy value of the model on the prior data pair in the preset model evaluation information;
determining an optimized value of the parameter based on the at least one target value, the prior data pair, and the posterior data pair; and
updating the parameter of the first model based on the optimized value.

2.    The method according to claim 1, wherein determining the optimized value of the parameter based on the at least one target value, the prior data pair, and the posterior data pair comprises:

obtaining a prior distribution of the parameter of the first model based on the prior data pair;
obtaining a loss value of the first model on the posterior data pair based on the posterior data pair and the at least one target value;
obtaining a posterior distribution of the parameter based on the prior distribution of the parameter and the loss value of the first model on the posterior data pair; and
determining the optimized value of the parameter based on the posterior distribution of the parameter.

3.    The method according to claim 2, wherein a value that is of the parameter and that corresponds to a maximum probability in the posterior distribution of the parameter is determined as the optimized value of the parameter.

4.    The method according to claim 2, wherein determining the optimized value of the parameter based on the posterior distribution of the parameter comprises:

performing sampling based on the posterior distribution of the parameter to obtain a plurality of values of the parameter; and

performing weighted averaging processing on the plurality of values of the parameter, to obtain the optimized value of the parameter.

5. The method according to any one of claims 1 to 4, wherein the parameter is all parameters of the first model.

6. The method according to any one of claims 1 to 4, wherein the parameter is a part of parameters of the first model, the first model sequentially comprises a feature extraction model and a classification model, and the part of parameters are parameters corresponding to the classification model;
traversing the plurality of reference values based on the preset model evaluation information, the first model, and the prior data pair, to obtain the at least one target value of the parameter comprises:

obtaining a prior feature data pair based on the prior data pair and the feature extraction model; and
traversing the plurality of reference values based on the preset model evaluation information, the classification model, and the prior feature data pair, to obtain the at least one target value of the parameter; and
determining the optimized value of the parameter based on the at least one target value, the prior data pair, and the posterior data pair comprises:

obtaining a posterior feature data pair based on the posterior data pair and the feature extraction model; and
determining the optimized value of the parameter based on the at least one target value, the prior feature data pair, the posterior feature data pair, and the classification model.

7. A model parameter optimization apparatus, comprising:

an obtaining module, configured to obtain a plurality of reference values of a parameter of a first model based on a prior data pair of the first model and a posterior data pair of the first model;
a calculation module, configured to traverse the plurality of reference values based on preset model evaluation information, the first model, and the prior data pair, to obtain at least one target value of the parameter, wherein a loss value that is of a model on the prior data pair and that corresponds to the target value is not greater than an upper bound of a loss value of a model on the prior data pair in the preset model evaluation information, and/or a test accuracy value that is of the model on the prior data pair and that corresponds to the target value is not less than a lower bound of a test accuracy value of the model on the prior data pair in the preset model evaluation information;
a determining module, configured to determine an optimized value of the parameter based on the at least one target value, the prior data pair, and the posterior data pair; and
an updating module, configured to update the parameter of the first model based on the optimized value.

8. The apparatus according to claim 7, wherein the determining module is configured to:

obtain a prior distribution of the parameter of the first model based on the prior data pair;
obtain a loss value of the first model on the posterior data pair based on the posterior data pair and the at least one target value;
obtain a posterior distribution of the parameter based on the prior distribution of the parameter and the loss value of the first model on the posterior data pair; and
determine the optimized value of the parameter based on the posterior distribution of the parameter.

9. The apparatus according to claim 8, wherein a value that is of the parameter and that corresponds to a maximum probability in the posterior distribution of the parameter is determined as the optimized value of the parameter.

10. The apparatus according to claim 8, wherein the determining module is further configured to:

perform sampling based on the posterior distribution of the parameter to obtain a plurality of values of the parameter; and
perform weighted averaging processing on the plurality of values of the parameter, to obtain the optimized value of the parameter.

11. The apparatus according to any one of claims 7 to 10, wherein the parameter is all parameters of the first model.

12. The method according to any one of claims 7 to 10, wherein the parameter is a part of parameters of the first model, the first model sequentially comprises a feature extraction model and a classification model, and the part of parameters are parameters corresponding to the classification model;
   the calculation module is configured to:

   obtain a prior feature data pair based on the prior data pair of the first model and the feature extraction model; and
   traverse the plurality of reference values based on the preset model evaluation information, the classification model, and the prior feature data pair, to obtain the at least one target value of the parameter; and
   the determining module is configured to:

   obtain a posterior feature data pair based on the posterior data pair of the first model and the feature extraction model; and
   determine the optimized value of the parameter based on the at least one target value, the prior feature data pair, the posterior feature data pair, and the classification model.

13. A model parameter optimization apparatus, comprising a processor and a memory, wherein the memory is configured to store program code, and the processor is configured to invoke the program code to perform the method according to any one of claims 1 to 6.

14. A computer-readable storage medium, wherein the computer-readable storage medium stores a computer program, and the computer program is executed by a processor, to implement the method according to any one of claims 1 to 6.

15. A computer program product, wherein when the computer program product runs on a computer, the computer is enabled to perform the method according to any one of claims 1 to 6.

101

Server end

102

FIG. 1

FIG. 2a

FIG. 2b

Obtain a plurality of reference values of a parameter of a first model based on a prior data pair of the first model and a posterior data pair of the first model ⌐ 301

Traverse the plurality of reference values based on preset model evaluation information, the first model, and the prior data pair, to obtain at least one target value of the parameter ⌐ 302

Determine an optimized value of the parameter based on the at least one target value, the prior data pair, and the posterior data pair ⌐ 303

Update the parameter of the first model based on the optimized value ⌐ 304

FIG. 3

| | |
|---|---|
| Obtain a plurality of reference values of a parameter of a classification model in a first model based on a prior data pair of the first model and a posterior data pair of the first model | 401 |
| Obtain a prior feature data pair based on the prior data pair of the first model and a feature extraction model | 402 |
| Traverse the plurality of reference values based on preset model evaluation information, the classification model, and the prior feature data pair, to obtain at least one target value of the parameter | 403 |
| Obtain a posterior feature data pair based on the posterior data pair of the first model and the feature extraction model | 404 |
| Determine an optimized value of the parameter based on the target value, the prior feature data pair, the posterior feature data pair, and the classification model | 405 |
| Update the parameter of the classification model based on the optimized value | 406 |

FIG. 4

FIG. 5a

FIG. 5b

Model parameter
optimization apparatus

Obtaining
module — 601

Calculation
module — 602

Determining
module — 603

Updating
module — 604

FIG. 6

Model parameter optimization apparatus 700

Memory 701

Processor 702

Bus 704

Communication
interface 703

FIG. 7

## INTERNATIONAL SEARCH REPORT

| International application No. |
|---|
| **PCT/CN2024/090976** |

**A.    CLASSIFICATION OF SUBJECT MATTER**

G06F30/27(2020.01)i

According to International Patent Classification (IPC) or to both national classification and IPC

**B.    FIELDS SEARCHED**

Minimum documentation searched (classification system followed by classification symbols)

IPC：G06F

Documentation searched other than minimum documentation to the extent that such documents are included in the fields searched

Electronic data base consulted during the international search (name of data base and, where practicable, search terms used)

CNABS: CNTXT; CNKI; 万方, WANFANG; 百度, BAIDU; WPABS; EPTXT; USTXT; WOTXT: 参数, 权重, 权值, 代价, 损失, 调优, 调整, 先验, 后验, 神经网络, 模型, 样本, 数据, 分布, 概率, parameter, weight, loss, adjust, optimize, prior, posterior, neural network, model, sample, data, distribution, probability

**C.    DOCUMENTS CONSIDERED TO BE RELEVANT**

| Category* | Citation of document, with indication, where appropriate, of the relevant passages | Relevant to claim No. |
|---|---|---|
| A | CN 113554148 A (NANJING UNIVERSITY OF SCIENCE AND TECHNOLOGY) 26 October 2021 (2021-10-26)<br>    description, paragraphs [0006]-[0070] | 1-15 |
| A | CN 115062752 A (HUAWEI TECHNOLOGIES CO., LTD.) 16 September 2022 (2022-09-16)<br>    entire document | 1-15 |
| A | CN 114219562 A (THE CHINESE UNIVERSITY OF HONG KONG, SHENZHEN et al.) 22 March 2022 (2022-03-22)<br>    entire document | 1-15 |
| A | CN 112651436 A (SHENZHEN ANRUAN TECHNOLOGY CO., LTD.) 13 April 2021 (2021-04-13)<br>    entire document | 1-15 |
| A | US 2022101106 A1 (SECONDMIND LTD.) 31 March 2022 (2022-03-31)<br>    entire document | 1-15 |

☑ Further documents are listed in the continuation of Box C.          ☑ See patent family annex.

| | |
|---|---|
| *    Special categories of cited documents:<br>"A"   document defining the general state of the art which is not considered to be of particular relevance<br>"D"   document cited by the applicant in the international application<br>"E"   earlier application or patent but published on or after the international filing date<br>"L"   document which may throw doubts on priority claim(s) or which is cited to establish the publication date of another citation or other special reason (as specified)<br>"O"   document referring to an oral disclosure, use, exhibition or other means<br>"P"   document published prior to the international filing date but later than the priority date claimed | "T"   later document published after the international filing date or priority date and not in conflict with the application but cited to understand the principle or theory underlying the invention<br>"X"   document of particular relevance; the claimed invention cannot be considered novel or cannot be considered to involve an inventive step when the document is taken alone<br>"Y"   document of particular relevance; the claimed invention cannot be considered to involve an inventive step when the document is combined with one or more other such documents, such combination being obvious to a person skilled in the art<br>"&"   document member of the same patent family |

| Date of the actual completion of the international search | Date of mailing of the international search report |
|---|---|
| **07 June 2024** | **06 July 2024** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

| International application No. |
| --- |
| **PCT/CN2024/090976** |

| C. | DOCUMENTS CONSIDERED TO BE RELEVANT | |
| --- | --- | --- |
| Category* | Citation of document, with indication, where appropriate, of the relevant passages | Relevant to claim No. |
| A | US 2021390449 A1 (BEIJING XIAOMI PINECONE ELECTRONICS CO., LTD.) 16 December 2021 (2021-12-16) entire document | 1-15 |

Form PCT/ISA/210 (second sheet) (July 2022)

# EP 4 711 971 A1

## INTERNATIONAL SEARCH REPORT
### Information on patent family members

| Patent document cited in search report | | | Publication date (day/month/year) | Patent family member(s) | | | Publication date (day/month/year) |
|---|---|---|---|---|---|---|---|
| CN | 113554148 | A | 26 October 2021 | None | | | |
| CN | 115062752 | A | 16 September 2022 | None | | | |
| CN | 114219562 | A | 22 March 2022 | None | | | |
| CN | 112651436 | A | 13 April 2021 | None | | | |
| US | 2022101106 | A1 | 31 March 2022 | US | 11475279 | B2 | 18 October 2022 |
| | | | | EP | 4026064 | A1 | 13 July 2022 |
| | | | | EP | 3786857 | A1 | 03 March 2021 |
| | | | | WO | 2021043670 | A1 | 11 March 2021 |
| US | 2021390449 | A1 | 16 December 2021 | EP | 3923202 | A1 | 15 December 2021 |
| | | | | EP | 3923202 | A4 | 15 December 2021 |
| | | | | CN | 111753895 | A | 09 October 2020 |

Form PCT/ISA/210 (patent family annex) (July 2022)

## EP 4 711 971 A1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202310657765